# EUROPÄISCHE PATENTSCHRIFT

(11) **EP 0 929 152 B1**
(45) Veröffentlichungstag und Bekanntmachung des Hinweises auf die Patenterteilung: **22.06.2005**
(21) Anmeldenummer: 98204270.7
(22) Anmeldetag: 16.12.1998
(51) Int. Cl.: H03H 11/04

(54) **Integrator-Filterschaltung**
Integrator filter circuit
Circuit intégrateur de filtrage

(30) Priorität: 07.01.1998 DE 19800206
(43) Veröffentlichungstag der Anmeldung: 14.07.1999
(73) Patentinhaber: Philips Intellectual Property & Standards GmbH, 20099 Hamburg (DE); Koninklijke Philips Electronics N.V., 5621 BA Eindhoven (NL)
(72) Erfinder: Kattner, Axel, Röntgenstrasse 24, 22335 Hamburg (DE); Gehrt, Holger, Röntgenstrasse 24, 22335 Hamburg (DE)
(74) Vertreter: von Laue, Hanns-Ulrich, Dipl.-Ing.

(56) Entgegenhaltungen:
- EP-A- 0 420 341
- EP-A- 0 455 298
- FUTAO YAMAGUCHI ET AL: "A NEW SINGLE-CHIP VIDEO SIGNAL-PROCESSING LSI FOR THE HIGH-BAND 8MMCAMCORDER" IEEE TRANSACTIONS ON CONSUMER ELECTRONICS, Bd. 39, Nr. 3, 1. August 1993 (1993-08-01), Seiten 413-420, XP000396312 ISSN: 0098-3063
- SODERSTRAND M A ET AL: "IMPLEMENTATION OF AN ACTIVE-R FILTER BUILDING BLOCK IN SEMI-CUSTOM VLSI" INTERNATIONAL JOURNAL OF ELECTRONICS, Bd. 76, Nr. 3, 1. März 1994 (1994-03-01), Seiten 469-482, XP000443337 ISSN: 0020-7217
- GRAY P.R.; MEYER R.G.: 'Analysis and Design of Analog Integrated Circuits', Third Edition, 1993, Kapitel 10.3.5, Seiten 677-681, John Wiley & Sons, Inc.

## Beschreibung

Die Erfindung betrifft eine Integrator-Filterschaltung zur Filterung eines Gegentaktsignals mittels wenigstens zweier Integrator-Signalfilter, die Integrator-Elemente aufweisen und deren Filterfrequenzen mittels den Integrator-Elementen zugeführten Steuerströmen einstellbar sind.

Solche Filter sind z.B. aus EP-A-420 341 bekannt.

Bei derartigen Integrator-Filterschaltungen, die als solche beispielsweise aus dem Philips IC TDA 9715 bekannt sind, besteht oftmals der Wunsch, die Filterfrequenzen der Integrator-Signalfilter zu verändern. Handelt es sich beispielsweise bei dem zu filternden Gegentaktsignal um ein Videosignal, das mehrere, mehreren Tonträgern aufmodulierte Tonsignale aufweist, so können diese Tonträger je nach Übertragungsnorm verschiedene Frequenzen aufweisen. Sind die Integrator-Signalfilter einer derartigen Integrator-Filterschaltung auf verschiedene Tonträgerfrequenzen ausgelegt, so müssen die Filterfrequenzen dieser Signalfilter je nach Frequenzen der Tonträger variiert werden. Dabei bleibt der Abstand der Tonträgerfrequenzen zueinander meist konstant, jedoch müssen beispielsweise alle Filterfrequenzen um 1 MHz nach oben oder nach unten verschoben werden. Bei Anordnungen nach dem Stande der Technik geschieht dies dadurch, daß die den Integrator-Elementen der Integrator-Signalfilter zugeführten Steuerströme entsprechend eingestellt werden. Dabei werden die Steuerströme für die Integrator-Elemente einzeln variiert. Dies bedeutet nicht unbeachtlichen schaltungstechnischen Aufwand.

Aus "A new Single-Chip Video Signal-Processing LSI for the High-Band 8mm Camcorder" von F. Yamaguchi et al, IEEE Transactions on Cosumer Electronics, Bd. 39, Nr. 3, 1. August 1993, Seiten 413-420, ist eine Schaltungsanordung bekannt, in welcher ein Referenzfilter in Abhängigkeit von der Frequenz eines Signals mittels eines Referenzstromes abgestimmt wird, und allen anderen Filter des Chips in Stromspiegeln replizierten Steuerströme dieses Referenzstromes zugeführt werden.

Es ist Aufgabe der Erfindung, die eingangs genannte Integrator-Filterschaltung dahingehend weiterzuentwickeln, daß eine derartige Veränderung der Filterfrequenzen mit möglichst geringem schaltungstechnischem Aufwand möglich ist.

Diese Aufgabe ist gemäß einer ersten Ausführungsform der Erfindung dadurch gelöst, daß die Integrator-Filterschaltung ein Referenz-Integrator-Filter aufweist, das wenigstens zwei in gleicher Technik wie die übrigen Integrator-Elemente aufgebaute Integrator-Elemente aufweist, das bei Abstimmung auf die Frequenz eines ihm zugeführtes Testsignals dieses bezüglich seiner Phase um einen definierten Wert dreht und dem ein Phasenkomparator nachgeschaltet ist, dem außerdem das Testsignal zugeführt wird,
daß aus dem Ausgangssignal des Phasenkomparators ein Korrektursignal abgeleitet wird, in Abhängigkeit dessen die den Integrator-Elementen des Referenz-Integrator-Filters und der Integrator-Signalfilter zugeführten Steuerströme erzeugt werden, mittels derer das Referenz-Integrator-Filter auf die Frequenz des ihm zugeführten Testsignals abgestimmt wird,
daß die Integrator-Signalfilter in Abhängigkeit des Korrektursignals auf Nennfrequenzen abgestimmt sind, wenn das Referenz-Integrator-Filter auf ein ihm zugeführtes Testsignal mit einer Referenzfrequenz abgestimmt ist,
und daß zur Abstimmung der Integrator-Signalfilter auf um von den Nennfrequenzen um einen vorgebbaren Verstimmungswert abweichende Filter-Frequenzen dem Referenz-Integrator-Filter ein um den vorgebbaren Verstimmungswert von der Referenzfrequenz abweichendes Testsignal zugeführt wird, auf das das Referenz-Integrator-Filter abgestimmt wird.

Innerhalb der Integrator-Filterschaltung ist ein Referenz-Integrator-Filter vorgesehen. Dieses Referenz-Integrator-Filter weist ebenso wie die Integrator-Signalfilter Integrator-Elemente auf. Wesentlich ist, daß diese Integrator-Elemente in gleicher Technik, d.h. mit den gleichen Bauelementen aufgebaut sind. Das Referenz-Integrator-Filter muß hingegen nicht die gleiche Filterordnung aufweisen wie die Integrator-Signalfilter, muß also nicht die gleiche Anzahl an Integrator-Elementen aufweisen. Auch die Verschaltung der Integrator-Elemente innerhalb des Referenz-Integrator-Filters kann von derjenigen innerhalb des Integrator-Signal-Filters abweichen. Jedoch müssen die Integrator-Elemente als solche in gleicher Technik aufgebaut sein.

Das Referenz-Integrator-Filter ist so aufgebaut, daß es ein ihm zugeführtes Testsignal, das eine bestimmte, bekannte Frequenz aufweist, dieses bezüglich seiner Phase um einen definierten Wert dreht, wenn das Referenz-Integrator-Filter auf die Frequenz dieses Testsignals abgestimmt ist. Die Abstimmung des Referenz-Integrator-Filters erfolgt ebenfalls mit Steuerströmen, die den Integrator-Elementen dieses Filters zugeführt werden.

Es ist ferner ein Phasenkomparator vorgesehen, dem einerseits das zu filternde Signal, das bezüglich seiner Phasenlage unverändert ist, und andererseits das Ausgangssignal des Referenz-Integrator-Filters, das bei Abstimmung auf die Frequenz des Testsignals bezüglich seiner Phase um 90 Grad gedreht ist, zugeführt wird.

In Abhängigkeit der Phasenbeziehungen dieser beiden Signale liefert der Phasenkomparator ein Ausgangssignal, das diese Phasenbeziehung angibt. Aus dem Ausgangssignal wird ein Korrektursignal abgeleitet, in Abhängigkeit dessen sowohl die den Integrator-Elementen des Referenz-Integator-Filters wie auch den Integrator-Elementen der Integrator-Signalfilter zugeführten Steuerströme erzeugt werden.

Damit wird erreicht, daß die dem Referenz-Integrator-Filter zugeführten Steuerströme in Abhängigkeit des Korrektursignals und damit auch in Abhängigkeit des Ausgangssignals des Phasenkomparators solange nachgesteuert werden, bis das Referenz-Integrator-Filter auf die Frequenz des Testsignals abgestimmt ist. Ist diese Abstimmung erzielt, beträgt also die Phasenverschiebung der beiden Eingangssignale des Phasenkomparators 90 Grad, liefert der Phasenkomparator ein entsprechendes Ausgangssignal, aus dem das Korrektursignal abgeleitet wird. Aus diesem wiederum sind die Steuerströme abgeleitet, die die Integrator-Elemente des Referenz-Integrator-Filters so einstellen, daß das Filter eben gerade auf diese Frequenz abgestimmt ist.

Aus dem Korrektursignal werden jedoch auch die Steuerströme abgeleitet, die den Integrator-Elementen der Integrator-Signalfilter zugeführt werden. Damit hat die Abstimmung des Referenz-Integrator-Filters auf die Frequenz des Testsignals und das in Abhängigkeit von dieser Abstimmung erzeugte Korrektursignal auch einen entsprechenden Einfluß auf die Steuerströme der Integrator-Elemente der Integrator-Signalfilter und damit auf deren Abstimmungsfrequenzen bzw. Filterfrequenzen.

Die Schaltung kann so ausgelegt sein, daß bei Abstimmung des Referenz-Integrator-Filters auf die Frequenz des Testsignals die Integrator-Signalfilter auf Nennfrequenzen abgestimmt sind. Es ist also bekannt bzw. durch entsprechende Auslegung der Schaltung wählbar, auf welche Frequenzen die Integrator-Signalfilter abgestimmt sind, wenn das Referenz-Integrator-Filter auf die Frequenz des ihm zugeführten Testsignals korrekt abgestimmt ist.

Damit ist einerseits erreicht worden, daß alle Integrator-Signalfilter korrekt abgestimmt sind, wenn das Referenz-Integratorfilter auf das Testsignal abgestimmt ist.

Zum anderen gestattet diese Anordnung jedoch auch, die Filterfrequenzen der Integrator-Signalfilter gemeinsam um einen bestimmten, vorgebbaren Verstimmungswert nach oben oder nach unten zu verschieben. Es können also die Filterfrequenzen der Integrator-Signalfilter beispielsweise alle um 1 MHz nach oben verschoben werden. Dazu wird die Frequenz des dem Referenz-Integrator zugeführten Testsignals um eben diesen Verstimmungswert verändert. Soll also beispielsweise eine Verschiebung der Filterfrequenzen der Integrator-Signalfilter gegenüber den Nennfrequenzen um 1 MHz nach oben erfolgen, wird auch die Frequenz des dem Referenz-Integrator-Filters zugeführten Testsignal um eben diesen Wert verändert. Durch diese Veränderung muß das Referenz-Integrator-Filter neu abgestimmt werden, was ein entsprechend verändertes Korrektursignal zur Folge hat. Durch das veränderte Korrektursignal werden auch die Steuerströme entsprechend verändert, so daß das Referenz-Integrator-Filter auf die veränderte Frequenz des Testsignals abgestimmt wird.

Da jedoch auch die Steuerströme der Integrator-Elemente der Integrator-Signalfilter aus dem Korrektursignal abgeleitet werden, werden auch diese entsprechend verändert, so daß eine Verschiebung der Filterfrequenzen der Integrator-Signalfilter um den gleichen Verstimmungswert erfolgt.

Durch die Erzeugung des Korrektursignals und den aus diesem Korrektursignal abgeleiteten Steuerströmen für die Integrator-Signalfilter wird also erreicht, daß eine gemeinsame Abstimmung auf neue Frequenzen bzw. Verstimmung um den Verstimmungswert für alle Integrator-Signalfilter gemeinsam erzielt wird. Der schaltungstechnische Aufwand wird gegenüber den Lösungen nach dem Stande der Technik schon dann verringert, wenn das Referenz-Integrator-Filter weniger Integrator-Elemente aufweist als die Integrator-Signalfilter zusammen.

Die oben angegebene Aufgabenstellung wird ferner durch eine zweite Ausführungsform der Erfindung gelöst, die dadurch gekennzeichnet ist, daß die Integrator-Filterschaltung ein Referenz-Integrator-Filter aufweist, das wenigstens zwei in gleicher Technik wie die übrigen Integrator-Elemente aufgebaute Integrator-Elemente aufweist, das bei Abstimmung auf die Frequenz eines ihm zugeführtes Testsignals dieses bezüglich seiner Phase um einen definierten Wert dreht und dem ein Phasenkomparator nachgeschaltet ist, dem außerdem das Testsignal zugeführt wird,
daß aus dem Ausgangssignal des Phasenkomparators ein Korrektursignal abgeleitet wird, in Abhängigkeit dessen die den Integrator-Elementen des Referenz-Integrator-Filters und der Integrator-Signalfilter zugeführten Steuerströme erzeugt werden,
mittels derer das Referenz-Integrator-Filter auf die Frequenz des ihm zugeführten Testsignals abgestimmt wird,
daß die Integrator-Signalfilter in Abhängigkeit des Korrektursignals auf Nennfrequenzen abgestimmt sind, wenn das Referenz-Integrator-Filter ausschließlich mittels der beiden Steuerströme auf ein ihm zugeführtes Testsignal mit einer Referenzfrequenz abgestimmt ist,
und daß zur Abstimmung der Integrator-Signalfilter auf um von den Nennfrequenzen um einen vorgebbaren Verstimmungswert abweichende Filter-Frequenzen den dem Referenz-Integrator-Filter zugeführten Steuerströmen wenigstens ein Schaltsteuerstrom überlagerbar ist, welcher so dimensioniert ist, daß bei Abstimmung des Referenz-Integrator-Filters auf das Testsignal mittels des Korrektursignals dieses eine Abstimmung der Integrator-Signalfilter auf Frequenzen bewirkt, welche von deren Nennfrequenzen um den Verstimmungswert abweichen.

Die zweite Ausführungsform der Erfindung ist grundsätzlich in gleicher Weise aufgebaut wie die erste Ausführungsform. Jedoch wird die Abstimmung der Integrator-Signalfilter auf Frequenzen, die von den Nennfrequenzen um den vorgebbaren Verstimmungswert abweichen, in anderer Weise vorgenommen.

Um diesen Verstimmungswert der Filterfrequenzen der Integrator-Signalfilter einzustellen, wird hier nicht die Frequenz des Testsignals verändert. Das Testsignal weist also in jedem Fall, auch bei einer vorzunehmenden Verstimmung, die Referenzfrequenz auf, die fest ist.

Um die oben beschriebene gemeinsame Verstimmung der Filterfrequenzen der Integrator-Signalfilter in Abhängigkeit des Korrektursignals zu erzielen, wird hingegen bei der zweiten Ausführungsform eine Überlagerung der Steuerströme, die den Integrator-Elementen des Referenz-Integrator-Filters zugeführt werden, mit Schaltsteuerströmen vorgenommen. Dabei sind diese Schaltsteuerströme so ausgelegt, daß durch die Überlagerung der Schaltsteuerströme mit den Steuerströmen bei Abstimmung des Referenz-Integrator-Filters auf die Referenzfrequenz eine entsprechende Variation der Steuerströme erforderlich ist, damit das Referenz-Integrator-Filter nach wie vor auf die Referenzfrequenz abgestimmt ist. Die Überlagerung der Steuerströme, die dem Referenz-Integrator-Filter zugeführt werden, mit den Schaltsteuerströmen hat also eine Variation der Steuerströme zur Folge, wenn das Filter nach wie vor auf die Referenzfrequenz abgestimmt sein soll. Damit tritt auch eine entsprechende Variation des Wertes des Korrektursignals ein. Da die den Integrator-Elementen der Integrator-Signalfilter zugeführten Steuerströme aus diesem Korrektursignal abgeleitet werden, werden deren Frequenzen in Abhängigkeit dieser Variation des Korrektursignals variiert. Für die zweite Ausführungsform der Erfindung sind also diese Schaltsteuerströme so auszulegen, daß die durch sie eintretende Variation des Korrektursignals gerade die gewünschte Verstimmung der Filterfrequenzen der Integrator-Signalfilter bewirkt.

Auch bei der zweiten Ausführungsform wird durch die eintretende Variation des Korrektursignals eine entsprechende Verstimmung der Filterfrequenzen der Integrator-Signalfilter erzielt, die gemeinsam für alle Integrator-Signalfilter erfolgt.

Die oben genannten Vorteile der ersten Ausführungsform gelten uneingeschränkt auch für die zweite Ausführungsform, bei der lediglich die Variation des Korrektursignals bei einer gewünschten Verstimmung auf andere Weise ausgelöst wird.

Die für beide Ausführungsformen der Erfindung vorteilhaft anwendbare Ausgestaltung gemäß Anspruch 3 gibt Schaltungselemente an, mittels derer auf einfache Weise das Korrektursignal generiert werden kann.

Ebenfalls für beide Ausführungsformen der Erfindung gibt Anspruch 4 eine vorteilhafte Auslegung des Referenz-Integrator-Filters an, bei der die Phasendrehung des Ausgangssignals dieses Filters auf relativ einfache Weise meßbar ist.

Die weiteren Ausgestaltungen der Erfindung beziehen sich auf beide Ausführungsformen und geben vorteilhafte Einsatzbereiche der erfindungsgemäßen Integrator-Filterschaltung an. Bei diesen Einsatzbereichen sind jeweils mehrere Integrator-Signalfilter vorzusehen, die gemeinsam um den Verstimmungswert variiert werden müssen. In allen diesen Fällen tritt durch die erfindungsgemäße Integrator-Filterschaltung eine beträchtliche Reduktion des Schaltungsaufwandes auf, da die einzusetzenden Integrator-Signalfilter meist höherer Ordnung sind bzw. weil mehrere hintereinander geschaltete Integrator-Signalfilter jeweils wenigstens zweiter Ordnung vorgesehen sind.

Nachfolgend wird anhand der Zeichnung ein Ausführungsbeispiel der Erfindung erläutert, das mit geringen Variationen für beide Ausführungsformen der Erfindung einsetzbar ist. Es zeigen:
Fig. 1 ein Integrator-Element, wie es sowohl für das Referenz-Integrator-Filter wie auch für die Referenz-Signalfilter vorgesehen ist, sowie eine Schaltungsanordnung zur Erzeugung der Steuerströme innerhalb des Referenz-Integrator-Filters,
Fig. 2 ein Blockschaltbild der gesamten erfindungsgemäßen Integrator-Filterschaltung und
Fig. 3 eine Schaltungsanordnung zur Erzeugung der Steuerströme für die Integrator-Elemente des Referenz-Integrator-Filters gemäß der zweiten Ausführungsform der Erfindung.

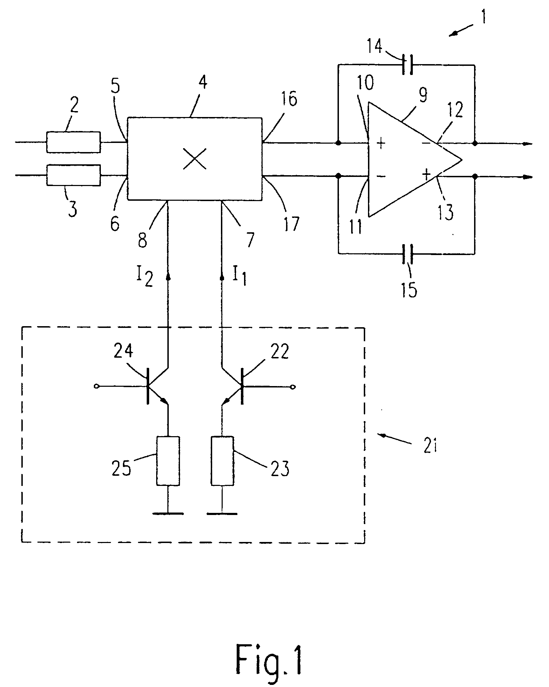

Ein in Fig. 1 dargestelltes Integrator-Element 1 ist in technisch gleicher Bauart sowohl in dem Referenz-Integrator-Filter wie auch in den Integrator-Signalfiltern der erfindungsgemäßen Integrator-Filterschaltung vorzusehen. Meist sind in einem Integrator-Filter mehrere Integrator-Elemente 1 vorgesehen, die auf verschiedene Weise verschaltet sind. So können auch die Integrator-Signalfilter und das Referenz-Integrator-Filter verschieden verschaltet sein. Wesentlich ist jedoch, daß die Integrator-Elemente 1 in beiden Filterarten auf gleiche Weise, d.h. in gleicher Technik aufgebaut sind. Ein derartiger Aufbau eines Integrator-Elementes 1 ist in Fig. 1 näher dargestellt.

Das Integrator-Element 1, dem eingangsseitig ein Gegentaktsignal zugeführt wird, weist für die beiden Signalelemente eingangsseitig Widerstände 2 und 3 auf. Die Ausgangssignale der Widerstände 2 und 3 gelangen auf Eingänge 5 und 6 eines Strommultiplizierers 4, der auch als Gilbert-Mulitplizierer bezeichnet wird. Der Strommultiplizierer 4 weist ferner Steuereingänge 7 und 8 auf, an dem ihm Steuerströme I₁ und I₂ zugeführt werden. Die Ausgangssignale des Strommultiplizierers 4, die an Ausgängen 16 und 17 zur Verfügung stehen, werden Eingängen 10 und 11 eines Gegentaktverstärkers 9 zugeführt. Dabei ist der Eingang 10 nichtinvertierend und der Eingang 11 invertierend ausgelegt. Der Gegentaktverstärker 9 weist ferner Ausgänge 12 und 13 auf, von denen der Ausgang 12 invertierend und der Ausgang 13 nichtinvertierend ausgelegt ist. Das Ausgangssignal des invertierenden Ausgangs 12 ist über eine Kapazität 14 auf den nichtinvertierenden Eingang rückgekoppelt. In entsprechender Weise ist das Ausgangssignal des nichtinvertierenden Ausgangs 13 über eine Kapazität 15 auf den invertierenden Eingang 11 ausgekoppelt. Die Ausgänge 12 und 13 liefern ebenfalls die Gegentakt-Ausgangssignale des Integrator-Elementes 1.

Eine Variation der Integrations-Zeitkonstanten des Integrator-Elementes 1 ist mittels Variation der Steuerströme I₁ und I₂ möglich. Durch Variation dieser Ströme wird die Impedanz am Eingang des Gegentaktverstärkers variiert, so daß die Integrations-Zeitkonstante, die von den Werten der Widerstände 2 und 3 sowie der Kapazitäten 14 und 15 abhängig ist, durch den variierten Einfluß der Widerstände 2 und 3 verändert.

Fig. 1 zeigt ebenfalls eine Schaltung 21 zur Erzeugung der Steuerströme I₁ und I₂, wie sie vorteilhaft innerhalb der Integrator-Signalfilter der erfindungsgemäßen Integrator-Filterschaltung vorgesehen sein können. So wird gemäß dieser Schaltung ein Spannungswert dem Basisanschluß eines Transistors 22 zugeführt, dessen Emitter über einen Widerstand 23 mit Masse gekoppelt ist und dessen Kollektor den Steuerstrom I₁ liefert, der in Abhängigkeit der Basisspannnung des Transistors 22 variiert. In entsprechender Weise wird mittels eines Transistors 24 und eines Widerstandes 25 der zweite Steuerstrom I₂ erzeugt.

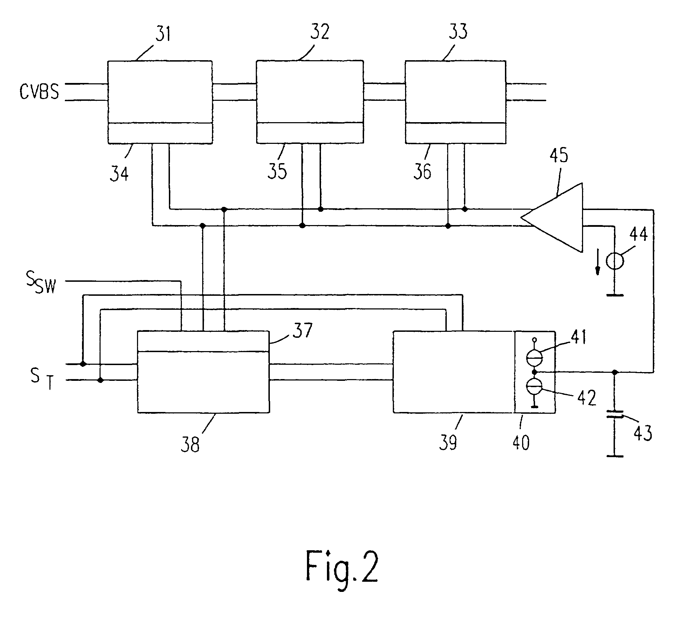

In Fig. 2 ist ein Blockschaltbild einer erfindungsgemäßen Integrator-Filterschaltung dargestellt. Die Integrator-Filterschaltung weist in diesem Ausführungsbeispiel drei Integrator-Signalfilter 31, 32 und 33 auf, die hintereinandergeschaltet sind, und die jeweils wenigstens zweiter Ordnung sind, die also jeweils wenigstens zwei Integrator-Elemente 1 gemäß Fig. 1 aufweisen. Die Art der Verschaltung der Integrator-Elemente untereinander kann dabei variieren.

Dem ersten Integrator-Signalfilter 31 wird eingangsseitig ein Videosignal zugeführt, in dem beispielsweise zwei Tonträger verschiedener Frequenzen enthalten sind, auf die Tonsignale aufmoduliert sind. Die Integrator-Signalfilter 31, 32 und 33 dienen dazu, diese Tonträgerfrequenzen möglichst gut zu unterdrücken. Damit müssen die Filterfrequenzen der Integrator-Signalfilter auf diese Frequenzen einstellbar sein. Da je nach Übertragungsnorm die Tonträgerfrequenzen variieren können, müssen auch die Filterfrequenzen der Integrator-Signalfilter 31 bis 33 entsprechend einstellbar sein.

Hierzu sind in der Figur Schaltungen 34, 35 und 36 angedeutet, die jeweils Schaltungen 21 entsprechend Fig. 1 aufweisen, welche zur Erzeugung der Steuerströme für die Integrator-Elemente der Integrator-Signalfilter 31, 32 und 33 eingesetzt werden.

Die Integrator-Filterschaltung gemäß Fig. 2 weist ferner ein Referenz-Integrator-Filter 38 auf, welchem eingangsseitig ein Gegentakt-Testsignal S_{T} zugeführt wird. Das Referenz-Integrator-Filter 38 weist ebenfalls Integrator-Elemente 1 gemäß Fig. 1 auf. Wesentlich ist, daß die Integrator-Elemente 1 in gleicher Weise aufgebaut sind wie die Integrator-Elemente der Signalfilterschaltungen 31, 32 und 33, d.h. die Integrator-Filter müssen in sich in gleicher Weise aufgebaut sein, können jedoch untereinander zur Erzielung der Filterwirkung verschieden verschaltet sein.

Vorteilhaft kann das Referenz-Integrator-Filter 38 als Tiefpaßfilter zweiter Ordnung ausgelegt sein, das bei Abstimmung auf die Frequenz des ihm zugeführten Testsignals S_{T} an seinen Ausgängen dieses Signal in 90 Grad gedrehter Phase liefert.

Es ist ferner ein Phasenkomparator 39 vorgesehen, dem einerseits das Ausgangssignal des Referenz-Integrator-Filters 38 und andererseits das Testsignal S_{T} zugeführt werden. Der Phasenkomparator steuert in Abhängigkeit der Phasenverschiebung dieser beiden Signale zueinander zwei steuerbare Stromquellen 41 und 42, die innerhalb einer Signalerzeugungsschaltung 40 vorgesehen sind. Dabei je nach Vorzeichen der Phasenabweichung der beiden dem Phasenkomparator 34Xwird zugeführten Signale zueinander entweder die Stromquelle 41 oder die Stromquelle 42 aktiviert. Die Dauer der Aktivierung hängt von dem Maße der Phasenverschiebung ab. Auf den Koppelpunkt der beiden Stromquellen 41 und 42 ist eine Kapazität 43 geschaltet, die mit ihrem anderen Anschluß auf ein Referenzpotential gekoppelt ist.

Damit wird mittels der Stromquellen 41 und 42 die Ladung der Kapazität 43 in Abhängigkeit der relativen Phasenverschiebung der beiden dem Phasenkomparator 39 zugeführten Signale entsprechend variiert.

Der über der Kapazität 43 auftretende Spannungsabfall wird mittels eines Komparators 45 mit einer Referenzspannung verglichen, die mittels einer Spannungsquelle 44 erzeugt wird. Der Komparator 45 liefert ausgangsseitig ein Korrektursignal, das den Schaltungen 34, 35 und 36 der Integrator-Signalfilter 31, 32 und 33 zur Erzeugung der Steuerströme zugeführt wird. Das Korrektursignal gelangt ferner an die Schaltung 37 des Referenz-Integrator-Filters, die ebenfalls zur Erzeugung der Steuerströme für die Integrator-Elemente des Referenz-Integrator-Filters 38 vorgesehen ist.

Die Schaltung gemäß Fig. 2 ist sowohl für eine Integrator-Filterschaltung gemäß der ersten Ausführungsform der Erfindung wie auch für ein solches gemäß der zweiten Ausführungsform der Erfindung mit geringen Variationen einsetzbar. Diese beiden Ausführungsformen werden nachfolgend getrennt erläutert.

Gemäß der ersten Ausführungsform wird eine Abstimmung der Frequenzen der Signalfilter in Abhängigkeit der Frequenz des Testsignals vorgenommen.

Weist das dem Referenz-Integrator-Filter 38 zugeführte Testsignal S_{T} eine Referenzfrequenz auf, die eine bekannte Frequenz darstellt, so wird durch das Referenz-Integrator-Filter 38 dieses Signal bezüglich seiner Phase um einen Wert gedreht. Die Größe dieses Wertes hängt davon ab, ob das Referenz-Integrator-Filter auf die Frequenz des Testsignals S_{T} abgestimmt ist. Ist dies der Fall, so ist die Phase des Ausgangssignals des Referenz-Integrator-Filters 38 gegenüber der Phase des Testsignals S_{T} um 90 Grad gedreht.

Der Phasenkomparator steuert die Stromquellen 41 und 42 in Abhängigkeit der Phasenbeziehung dieser beiden Signale zueinander. In Abhängigkeit der dadurch variierten Ladung der Kapazität 43 liefert der Komparator 45 ein Korrektursignal. In Abhängigkeit dieses Korrektursignals wird die Abstimmung des Referenz-Integrator-Filters 38 durch entsprechende Variation der Steuerströme mittels der Schaltung 37 variiert. Die Schaltung ist so ausgelegt, daß durch die Variation des Korrektursignals in Abhängigkeit der Phasenverschiebung des Testsignals S_{T} und des Ausgangssignals des Referenz-Integrator-Filters 38 das Referenz-Integrator-Filter 38 so abgestimmt wird, daß es auf die Frequenz des Testsignals abgestimmt ist. Dabei weist das Ausgangssignal des Referenz-Integrator-Filters 38 eine Phasenverschiebung von 90 Grad gegenüber dem Testsignal S_{T} auf. In diesem Zustand hat das Korrektursignal, das von dem Komparator 35 geliefert wird, einen Wert, der eine entsprechende Erzeugung der Steuerströme innerhalb der Schaltungen 34, 35 und 36 der Signal-Integrator-Filter 31, 32 und 33 nach sich zieht, bei der diese Filter gerade auf ihre Nennfrequenzen abgestimmt sind. So kann beispielsweise das Signalfilter 31 auf eine Frequenz von 4,5 MHz und die Signalfilter 32 und 33 auf eine Frequenz von 4,75 MHz abgestimmt sein.

Solange die Frequenz des Testsignals S_{T} den konstanten Wert der Referenzfrequenz aufweist, wird die Nachregelung der Abstimmung des Integrator-Filters 38 immer so arbeiten, daß das Referenz-Integrator-Filter auf die Frequenz dieses Eingangssignals abgestimmt ist. Das dabei mittels des Komparators abgeleitete Korrektursignal hält die Filterfrequenzen der Integrator-Signalfilter 31, 32 und 33 auf ihre Nennfrequenzen.

Sollen hingegen die Filterfrequenzen der Signalfilter 31, 32 und 33 zur Abstimmung auf andere Tonträgerfrequenzen verändert werden, soll also beispielsweise eine Abstimmung auf 5,5 und 5,75 MHz statt auf 4,5 und 4,75 MHz vorgenommen werden, so wird eine entsprechende Variation der Frequenz des Testsignals S_{T} vorgenommen. In diesem Beispielsfalle sollen die Signalfilter auf Frequenzen abgestimmt werden, die um einen Verstimmungswert + 1,0 MHz über ihren Nennfrequenzen liegen. Hierzu wird die Frequenz des dem Referenz-Integrator-Filters 38 zugeführten Testsignals S_{T} um ebenfalls diesen Verstimmungswert + 1,0 MHz verändert. Betrug die Frequenz des Testsignals S_{T} beispielsweise vorher 4 MHz so beträgt sie nun 5 MHz. Da das Referenz-Integrator-Filter 38 auf diese neue Frequenz abgestimmt werden muß und dazu andere Steuerströme erforderlich sind, wird durch die Schaltung mit dem Phasenkomparator 39, den Stromquellen 41 und 42, der Kapazität 43 und dem Komparator 45 eine entsprechende Variation des Korrektursignals erzeugt, die entsprechend veränderte Steuerströme, die mittels der Schaltungen 37 erzeugt werden, für das Referenz-Integrator-Filter 38 zur Folge hat. Ist das Referenz-Integrator-Filter 38 auf die veränderte Frequenz des Testsignals S_{T} abgestimmt, hat sich in diesem eingeschwungenen Zustand auch die Höhe des Korrektursignals verändert. Damit erzeugen die Schaltungen 34, 35 und 36 andere, veränderte Steuerströme für die Integrator-Signalfilter 31, 32 und 33, die somit auf andere Frequenzen abgestimmt werden. Die Schaltungsanordnung ist dabei so ausgelegt, daß entsprechend der Verstimmung der Referenzfrequenz um + 1,0 MHz ebenfalls eine Verstimmung der Signalfilter-Frequenzen der Integrator-Signal-Filter 31, 32 und 33 um diesen Wert erfolgt.

Damit ist durch die Variation der Frequenz des Steuersignals S_{T} eine entsprechende Variation der Filterfrequenzen der Integrator-Signalfilter 31, 32 und 33 ohne zusätzlichen Schaltungsaufwand gelungen.

Die Schaltungsanordnung gemäß Fig. 2 ist ebenfalls für die zweite Ausführungsform der Erfindung einsetzbar, bei der jedoch zur Variation der Filterfrequenzen der Integrator-Signalfilter 31, 32 und 33 ein Schaltsignal S_{SW} eingesetzt wird.

Bei dieser zweiten Ausführungsform bleibt die Frequenz des Testsignals S_{T} konstant, beträgt also immer die Referenzfrequenz.

Solange kein Schaltsignal S_{SW} der Schaltungsanordnung 37 zur Erzeugung der Steuerströme für das Referenz-Integrator-Filter 38 zugeführt wird, gilt das oben für die erste Ausführungsform gesagte. Das Referenz-Integrator-Filter 38 ist auf die Referenzfrequenz des Testsignals S_{T} abgestimmt und die Integrator-Signalfilter 31, 32 und 33 sind auf ihre Nennfrequenzen abgestimmt.

Zur Variation der Filterfrequenzen der Integrator-Signalfilter 31, 32 und 33 wird bei dieser zweiten Ausführungsform der Erfindung das Schaltsignal S_{SW} eingesetzt. Aus dem Schaltsignal S_{SW} werden Schaltsteuerströme abgeleitet, die innerhalb der Schaltung 37 den Steuerströmen für die Integrator-Elemente des Referenz-Integrator-Filters 38 überlagert werden. Durch diese Überlagerung mit den Steuerströmen tritt eine Veränderung der Abstimmfrequenz des Referenz-Integrator-Filters 38 ein. Damit tritt auch eine Änderung der Phasenverschiebung des Ausganssignals des Referenz-Integrator-Filters 38 zu dem Testsignal S_{T} ein, so daß der Phasenkomparator 39 die Stromquellen 41 und 42 in entsprechend veränderter Weise steuert. Dadurch wird das Korrektursignal, das der Komparator 45 liefert, ebenfalls variiert, so daß die Steuerströme, die innerhalb der Schaltung 37 für das Referenz-Integrator-Filter erzeugt werden, ebenfalls variiert werden. Dies geschieht in der Weise, daß durch die Nachregelung schließlich das Referenz-Integrator-Filter 38 trotz der den Steuerströmen überlagerten Schaltströme wieder auf die Referenzfrequenz des Testsignals S_{T} abgestimmt ist. Die den Integratoren des referenzfilters zugeführten Steuerströme sind wieder dieselben. Im Ergebnis hat sich jedoch hierbei der Wert des von dem Komparator 45 gelieferten Korrektursignals verändert, so daß auch in den Schaltungen 34, 35 und 36 zur Erzeugung der Steuerströme für die in den Integrator-Signalfiltern 31, 32 und 33 vorgesehenen Integrator-Elementen eine entsprechende Variation der erzeugten Steuerströme eintritt. Damit werden die Integrator-Signalfilter 31, 32 und 33 auf entsprechend veränderte Frequenzen abgestimmt.

Im Ergebnis kann damit in Abhängigkeit des Schaltsignals S_{SW} eine Variation der Abstimmfrequenzen der Integrator-Signalfilter 31, 32 und 33 auf einfache Weise erfolgen. Es können auch mehrere Schaltsignale vorgesehen sein, welche Verstimmungen verschiedener Größe bewirken.

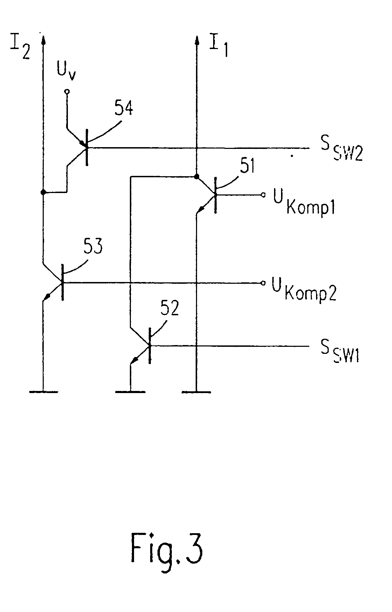

In Fig. 3 ist eine vorteilhafte Ausgestaltung der Schaltung 37 dargestellt, die zur Erzeugung der Steuerströme für das Referenz-Integrator-Filter 38 gemäß Fig. 2 dient.

In Fig. 3 ist ein npn-Transistor 51 dargestellt, dessen Basis ein erstes Signal Uₖₒₘₚₜ des Gegentakt-Korrektur-Signals zugeführt wird, wie es von dem Komparator 45 gemäß Fig. 2 beliefert wird.

Der Transistor 51 ist mit seinem Emitter gegen ein Bezugspotential gekoppelt. Sein Kollektor liefert einen ersten Steuerstrom I₁.

In der Schaltung gemäß Fig. 3 ist ferner ein weiterer npn-Transistor 53 vorgesehen, dem basisseitig das zweite Signal Uₖₒₘₚ₂ des Gegentakt-Korrektor-Signals zugeführt wird. Kollektorseitig liefert der Transistor 53 das zweite Steuersignal I₂.

Die Steuersignale I₁ und I₂ werden den Integrator-Elementen innerhalb des Referenz-Integrator-Filters 38 gemäß Fig. 2 zugeführt.

In Abhängigkeit der Komponenten Uₖₒₘₚ₁ und Uₖₒₘₚ₂ des Gegentakt-Korrektur-Signals werden die Steuerströme I₁ und I₂ zur Abstimmung der Frequenz des Referenz-Integrator-Filters 38 gemäß Fig. 2 erzeugt.

Bei der zweiten Ausführungsform der Erfindung, die oben anhand Fig. 2 erläutert wurde, ist jedoch zusätzlich ein Schaltsignal S_{SW} vorgesehen, das die entsprechende Verstimmung der Filterfrequenzen der Signal-Integrator-Filter 31, 32 und 33 gemäß Fig. 2 bewirkt.

Innerhalb der Schaltung gemäß Fig. 3 wird ein Schaltsignal S_{SW1}, das aus dem Schaltsignal S_{SW} abgeleitet sein kann oder auch unmittelbar dieses darstellen kann, der Basis eines npn-Transistors 52 zugeführt, dessen Emitter mit Bezugspotential und dessen Kollektor mit dem Kollektor des Transistors 51 gekoppelt ist. Bei Aktivierung des Schaltsignals S_{SW} wird dem Steuerstrom I₁ damit zusätzlich der Kollektorstrom des Transistors 52 überlagert, in diesem Falle mit gleichem Vorzeichen.

In der Schaltungsanordnung gemäß Fig. 3 ist ferner ein pnp-Transistor 54 vorgesehen, dem basisseitig das Schaltsignal S_{SW2} zugeführt wird, das aus dem schaltsignal S_{SW} abgeleitet sein kann oder unmittelbar dieses darstellen kann. Der Emitter des Transistors 54 ist mit einem Versorgungspotential Uᵥ und der Kollektor des Transistors 54 ist mit dem Kollektor des Transistors 53 gekoppelt. Bei Aktivierung des Schaltsignals S_{SW} wird der zweite Steuerstrom I₂ mit dem Kollektorstrom des Transistors 54 überlagert, in diesem Falle mit gegensätzlichem Vorzeichen.

Damit wird innerhalb der Schaltung gemäß Fig. 3 eine Überlagerung der Steuerströme I₁ und I₂ mit den Kollektorströmen der Transistoren 52 und 54 mit jeweils unterschiedlichem Vorzeichen vorgenommen, wenn das Schaltsignal S_{SW} aktiviert ist. Damit wird die oben erläuterte Wirkung für die Nachführung der Abstimmung des Referenz-Integrator-Filters 38 innerhalb der Schaltungsanordnung gemäß Fig. 2 bei der zweiten Ausführungsform der Erfindung erzielt.

Es können ggf. mehrere verschiedene Schaltsteuerströme vorgesehen sein, welche jeweils eine verschieden große Verstimmung der Signalfilter-Frequenzen bewirken. In der Schaltung gemäß Fig. 3 sind dann weitere Transistoren entsprechend den Transistoren 52 und 54 vorzusehen.

## Patentansprüche

1. Integrator-Filterschaltung zur Filterung eines Gegentaktsignals mittels wenigstens zweier Integrator-Signalfilter (31,32,33), die Integrator-Elemente (1) aufweisen und deren Filterfrequenzen mittels den Integrator-Elementen (1) zugeführten Steuerströmen (I_{n,1},I_{n,2}) einstellbar sind,
**dadurch gekennzeichnet,**
**daß** die Integrator-Filterschaltung ein Referenz-Integrator-Filter (38) aufweist, das wenigstens zwei in gleicher Technik wie die übrigen Integrator-Elemente (1) aufgebaute Integrator-Elemente (1) aufweist, das bei Abstimmung auf die Frequenz eines ihm zugeführtes Testsignals dieses bezüglich seiner Phase um einen definierten Wert dreht und dem ein Phasenkomparator (39) nachgeschaltet ist, dem außerdem das Testsignal zugeführt wird,
**daß** aus dem Ausgangssignal des Phasenkomparators (39) ein Korrektursignal abgeleitet wird, in Abhängigkeit dessen die den Integrator-Elementen (1) des Referenz-Integrator-Filters (38) und der Integrator-Signalfilter (31,32,33) zugeführten Steuerströme (I_{n,1},I_{n,2}) erzeugt werden, mittels derer das Referenz-Integrator-Filter (38) auf die Frequenz des ihm zugeführten Testsignals abgestimmt wird,
**daß** die Integrator-Signalfilter (31,32,33) in Abhängigkeit des Korrektursignals auf Nennfrequenzen abgestimmt sind, wenn das Referenz-Integrator-Filter (38) auf ein ihm zugeführtes Testsignal mit einer Referenzfrequenz abgestimmt ist,
und **daß** zur Abstimmung der Integrator-Signalfilter (31,32,33) auf um von den Nennfrequenzen um einen vorgebbaren Verstimmungswert abweichende Filter-Frequenzen dem Referenz-Integrator-Filter (38) ein um den vorgebbaren Verstimmungswert von der Referenzfrequenz abweichendes Testsignal zugeführt wird, auf das das Referenz-Integrator-Filter (38) abgestimmt wird.

2. Integrator-Filterschaltung zur Filterung eines Gegentaktsignals mittels wenigstens zweier Integrator-Signalfilter (31,32,33), die Integrator-Elemente (1) aufweisen und deren Filterfrequenzen mittels den Integrator-Elementen (1) zugeführten Steuerströmen (I_{n,1},I_{n,2}) einstellbar sind,
**dadurch gekennzeichnet,**
**daß** die Integrator-Filterschaltung ein Referenz-Integrator-Filter (38) aufweist, das wenigstens zwei in gleicher Technik wie die übrigen Integrator-Elemente (1) aufgebaute Integrator-Elemente (1) aufweist, das bei Abstimmung auf die Frequenz eines ihm zugeführtes Testsignals dieses bezüglich seiner Phase um einen definierten Wert dreht und dem ein Phasenkomparator (39) nachgeschaltet ist, dem außerdem das Testsignal zugeführt wird,
**daß** aus dem Ausgangssignal des Phasenkomparators (39) ein Korrektursignal abgeleitet wird, in Abhängigkeit dessen die den Integrator-Elementen (1) des Referenz-Integrator-Filters (38) und der Integrator-Signalfilter (31,32,33) zugeführten Steuerströme (I_{n,1},I_{n,2}) erzeugt werden, mittels derer das Referenz-Integrator-Filter (38) auf die Frequenz des ihm zugeführten Testsignals abgestimmt wird,
**daß** die Integrator-Signalfilter (31,32,33) in Abhängigkeit des Korrektursignals auf Nennfrequenzen abgestimmt sind, wenn das Referenz-Integrator-Filter (38) ausschließlich mittels der beiden Steuerströme auf ein ihm zugeführtes Testsignal mit einer Referenzfrequenz abgestimmt ist,
und **daß** zur Abstimmung der Integrator-Signalfilter (31,32,33) auf um von den Nennfrequenzen um einen vorgebbaren Verstimmungswert abweichende Filter-Frequenzen den dem Referenz-Integrator-Filter (38) zugeführten Steuerströmen wenigstens eine Schaltsteuerstrom überlagerbar ist, welcher so dimensioniert ist, daß bei Abstimmung des Referenz-Integrator-Filters (38) auf das Testsignal mittels des Korrektursignals dieses eine Abstimmung der Integrator-Signalfilter (31,32,33) auf Frequenzen bewirkt, welche von deren Nennfrequenzen um den Verstimmungswert abweichen.

3. Integrator-Filterschaltung nach Anspruch 1 oder 2, **dadurch gekennzeichnet, daß** in Abhängigkeit des Ausgangssignals des Phasenkomparators (39) zwei Stromquellen (41,42) angesteuert werden, welche eine Kapazität (43) mit Strömen unterschiedlichen Vorzeichens laden bzw. entladen, und daß ein Komparator (45) vorgesehen ist, dem an einem ersten Eingang die über der Kapazität abfallende Spannung und an einem zweiten Eingang eine Referenzspannung (Uₖₒₘₚ) zugeführt wird und der ausgangsseitig das Korrektursignal liefert.

4. Integrator-Filterschaltung nach Anspruch 1 oder 2, **dadurch gekennzeichnet, daß** das Referenz-Integrator-Filter (38) zwei Integrator-Elemente (1) aufweist und als Tiefpaßfilter zweiter Ordnung ausgelegt ist, welches bei Abstimmung auf die Frequenz des Testsignals dessen Phase um 90 Grad dreht.

5. Integrator-Filterschaltung nach Anspruch 1 oder 2, **dadurch gekennzeichnet, daß** es sich bei dem zu filternden Gegentaktsignal um ein Videosignal handelt, das auf einen oder mehrere Tonträger aufmodulierte Tonsignale aufweist (CVBS), und daß die Integrator-Signalfilter (31,32,33) zur Ausfilterung der Tonträger ausgelegt sind.

6. Integrator-Filterschaltung nach Anspruch 4, **dadurch gekennzeichnet, daß** die Integrator-Signalfilter ein erstes Signalfilter (31) dritter, und ein zweites (32) und drittes Signalfilter (33) jeweils zweiter Ordnung aufweisen.

7. Integrator-Filterschaltung nach Anspruch 5, **dadurch gekennzeichnet, daß** das erste und das zweite Integrator-Signalfilter (31,32) zur Ausfilterung eines ersten Tonträgers ausgelegt sind und daß das dritte Integrator-Signalfilter (33) zur Ausfilterung eines zweiten Tonträgers ausgelegt sind, welcher eine kleinere Amplitude aufweist als der erste Tonträger.

8. Integrator-Filterschaltung nach Anspruch 1 oder 2, **dadurch gekennzeichnet, daß** es sich bei dem zu filternden Gegentaktsignal um ein Videosignal handelt, das ein auf einen Farbträger aufmoduliertes Farbsignale aufweist und daß die Integrator-Signalfilter (31,32,33) zur Ausfilterung des Farbträgers ausgelegt sind.

## Claims

1. An integrator filter circuit for filtering a push-pull signal by means of at least two integrator signal filters (31, 32, 33) comprising integrator elements (1), whose filter frequencies are adjustable by means of control currents (I_{n,1}, I_{n,2}) applied to the integrator elements (1), **characterized in that** the integrator filter circuit comprises a reference integrator filter (38) having at least two integrator elements (1) built up in an identical technique as the other integrator elements (1), which reference integrator filter, when tuned to the frequency of a test signal applied thereto, shifts the phase of said test signal by a defined value, and which is arranged subsequent to a phase comparator (39) which also receives the test signal, **in that** a correction signal is derived from the output signal of the phase comparator (39), in dependence upon which correction signal the control currents (I_{n,1}, I_{n,2}) applied to the integrator elements (1) of the reference integrator filter (38) and the integrator signal filters (31, 32, 33) are generated, by means of which control currents the reference integrator filter (38) is tuned to the frequency of the test signal applied thereto, **in that** the integrator signal filters (31, 32, 33) are tuned to rated frequencies in dependence upon the correction signal when the reference integrator filter (38) is tuned to a reference frequency test signal applied thereto, and **in that**, for tuning the integrator signal filters (31, 32, 33) to filter frequencies deviating by a predeterminable detuning value from the rated frequencies, a test signal deviating by the predeterminable detuning value from the reference frequency is applied to the reference integrator filter (38) which is tuned to said test signal.

2. An integrator filter circuit for filtering a push-pull signal by means of at least two integrator signal filters (31, 32, 33) comprising integrator elements (1), whose filter frequencies are adjustable by means of control currents (I_{n,1}, I_{n,2}) applied to the integrator elements (1), **characterized in that** the integrator filter circuit comprises a reference integrator filter (38) having at least two integrator elements (1) built up in an identical technique as the other integrator elements (1), which reference integrator filter, when tuned to the frequency of a test signal applied thereto, shifts the phase of said test signal by a defined value, and which is arranged subsequent to a phase comparator (39) which also receives the test signal, **in that** a correction signal is derived from the output signal of the phase comparator (39), in dependence upon which correction signal the control currents (I_{n,1}, I_{n,2}) applied to the integrator elements (1) of the reference integrator filter (38) and the integrator signal filters (31, 32, 33) are generated, by means of which control currents the reference integrator filter (38) is tuned to the frequency of the test signal applied thereto, **in that** the integrator signal filters (31, 32, 33) are tuned to rated frequencies in dependence upon the correction signal when the reference integrator filter (38) is tuned exclusively by means of the two control currents to a reference frequency test signal applied thereto, and **in that**, for tuning the integrator signal filters (31, 32, 33) at filter frequencies deviating by a predeterminable detuning value from the rated frequencies, at least a switching control current is superimposable on the control currents applied to the reference integrator filter (38), which switching control current is dimensioned in such a way that, when tuning the reference integrator filter (38) to the test signal by means of the correction signal, this test signal causes the integrator signal filters (31, 32, 33) to tune to frequencies which deviate by the detuning value from their rated frequencies.

3. An integrator filter circuit as claimed in claim 1 or 2, **characterized in that**, in dependence upon the output signal of the phase comparator (39), two current sources (41, 42) are controlled which charge or discharge a capacitance (43) with currents of different signs, and **in that** a comparator (45) is provided, a first input of which receives the voltage dropping across the capacitance, and a second input of which receives a reference voltage (Uₖₒₘₚ), and whose output supplies the correction signal.

4. An integrator filter circuit as claimed in claim 1 or 2, **characterized in that** the reference integrator filter (38) comprises two integrator elements (1) and is implemented as a second-order low-pass filter which, when tuned to the frequency of the test signal, shifts its phase by 90 degrees.

5. An integrator filter circuit as claimed in claim 1 or 2, **characterized in that** the push-pull signal to be filtered is a video signal which comprises sound signals (CVBS) modulated on one or more sound carriers, and **in that** the integrator signal filters (31, 32, 33) are implemented for filtering the sound carriers.

6. An integrator filter circuit as claimed in claim 4, **characterized in that** the integrator signal filters comprise a first, third-order signal filter (31), a second, second-order signal filter (32) and a third, second-order signal filter (33).

7. An integrator filter circuit as claimed in claim 5, **characterized in that** the first and the second integrator signal filters (31, 32) are implemented for filtering a first sound carrier, and **in that** the third integrator signal filter (33) is implemented for filtering a second sound carrier having a smaller amplitude than the first sound carrier.

8. An integrator filter circuit as claimed in claim 1 or 2, **characterized in that** the push-pull signal to be filtered is a video signal comprising chrominance signals modulated on a chrominance subcarrier, and **in that** the integrator signal filters (31, 32, 33) are implemented for filtering the chrominance subcarrier.

## Revendications

1. Circuit de filtrage d'intégrateur pour le filtrage d'un signal symétrique à l'aide d'au moins deux filtres de signaux d'intégrateur (31, 32, 33) qui présentent des éléments intégrateurs (1) et dont les fréquences de filtrage sont réglables à l'aide des courants de commande (I_{n,1}, I_{n,2}) amenés aux éléments intégrateurs (1),
**caractérisé en ce**
le circuit de filtrage d'intégrateur possède un filtre d'intégrateur de référence (38), qui présente au moins deux éléments intégrateurs (1) conçus dans la même technique que les autres éléments intégrateurs (1), qui, en cas d'accord à la fréquence d'un signal de test qui lui est amené, déphase celui-ci d'une valeur définie et en aval duquel est monté un comparateur de phase (39) auquel est amené par ailleurs le signal de test ;
qu'à partir du signal de sortie du comparateur de phase (39) est déduit un signal de correction en fonction duquel sont produits les courants de commande (I_{n,1}, I_{n,2}) amenés aux éléments intégrateurs (1) du filtre d'intégrateur de référence (38) et aux filtres de signaux d'intégrateur (31, 32, 33), à l'aide desquels le filtre d'intégrateur de référence (38) est accordé à la fréquence du signal de test qui lui est amené ;
que les filtres de signaux d'intégrateur (31, 32, 33) sont accordés à des fréquences nominales en fonction du signal de correction lorsque le filtre d'intégrateur de référence (38) est accordé à un signal de test amené à celui-ci avec une fréquence de référence ;
et qu'en vue de l'accord du filtre de signaux d'intégrateur (31, 32, 33) à des fréquences de filtrage s'écartant des fréquences nominales d'une valeur de désaccord à déterminer préalablement est amené au filtre d'intégrateur de référence (38) un signal de test, s'écartant de la fréquence de référence de la valeur de désaccord à déterminer préalablement, sur lequel le filtre d'intégrateur de référence (38) est accordé.

2. Circuit de filtrage d'intégrateur pour le filtrage d'un signal symétrique à l'aide d'au moins deux filtres de signaux d'intégrateur (31, 32, 33) qui présentent des éléments intégrateurs (1) et dont les fréquences de filtrage sont réglables à l'aide des courants de commande (I_{n,1}, I_{n,2}) amenés aux éléments intégrateurs (1),
**caractérisé en ce**
**que** le circuit de filtrage d'intégrateur présente un filtre d'intégrateur de référence (38) qui possède au moins deux éléments intégrateurs (1) conçus dans la même technique que les autres éléments intégrateurs (1), qui, en cas d'accord à la fréquence d'un signal de test qui lui est amené, déphase celui-ci d'une valeur définie et en aval duquel est monté un comparateur de phases (39) auquel est par ailleurs amené le signal de test ;
**qu'**à partir du signal de sortie du comparateur de phase (39), est déduit un signal de correction en fonction duquel sont produits les courants de commande (I_{n,1}, I_{n,2}), amenés aux éléments intégrateurs (1) du filtre d'intégrateur de référence (38) et des filtres de signaux d'intégrateur (31, 32, 33), à l'aide desquels le filtre d'intégrateur de référence (38) est accordé à la fréquence du signal de test qui lui est amené ;
**que** les filtres de signaux d'intégrateur (31, 32, 33) sont accordés en fonction du signal de correction aux fréquences nominales lorsque le filtre d'intégrateur de référence (38) est exclusivement accordé à l'aide des deux courants de commande à un signal de test qui lui est amené avec une fréquence de référence ;
et **que**, pour l'accord des filtres de signaux d'intégrateur (31, 32, 33) à des fréquences de filtrage s'écartant des fréquences nominales d'une valeur de désaccord à déterminer préalablement, il est possible de superposer aux courants de commande amenés au filtre d'intégrateur de référence (38) au moins un courant de commande de commutation dimensionné de telle sorte qu'en cas d'accord du filtre d'intégrateur de référence (38) sur le signal de test à l'aide du signal de correction, celui-ci provoque un accord des filtres de signaux d'intégrateur (31, 32, 33) à des fréquences qui s'écartent de leurs fréquences nominales de la valeur de désaccord.

3. Circuit de filtrage d'intégrateur selon l'une des revendications 1 ou 2,
**caractérisé en ce**
**qu'**en fonction du signal de sortie du comparateur de phase (39), deux sources de courant (41, 42) qui chargent ou déchargent une capacité (43) avec des courants de signes différents sont commandées et qu'il est prévu un comparateur (45) auquel est amené à une première entrée la tension appliquée sur la capacité et, à une deuxième entrée, une tension de référence (U_{comp}) et qui délivre le signal de correction côté sortie.

4. Circuit de filtrage d'intégrateur selon l'une des revendications 1 ou 2,
**caractérisé en ce**
**que** le filtre d'intégrateur de référence (38) présente deux éléments intégrateurs (1) et est conçu comme un filtre passe-bas de deuxième ordre qui est déphasé de 90 degrés en cas d'accord à la fréquence du signal de test.

5. Circuit de filtrage d'intégrateur selon l'une des revendications 1 ou 2, **caractérisé en ce que** le signal symétrique à filtrer est un signal vidéo qui présente des signaux audio modulés sur une ou plusieurs porteuses audio (CVBS) et que les filtres de signaux d'intégrateur (31, 32, 33) sont conçus pour le filtrage des porteuses audio.

6. Circuit de filtrage d'intégrateur selon la revendication 4, **caractérisé en ce que** le filtre de signaux d'intégrateur présente un premier filtre de signaux (31) de troisième ordre et des deuxième (32) et troisième (33) filtres de signaux de deuxième ordre chacun.

7. Circuit de filtrage d'intégrateur selon la revendication 5, **caractérisé en ce que** les premier et deuxième filtres de signaux d'intégrateur (31, 32) pour le filtrage d'une première porteuse audio et que le troisième filtre de signaux d'intégrateur (33) est conçu pour le filtrage d'une deuxième porteuse audio qui présente une amplitude inférieure à la première porteuse audio.

8. Circuit de filtrage d'intégrateur selon l'une des revendications 1 ou 2,
**caractérisé en ce**
**que** le signal symétrique à filtrer est un signal vidéo qui présente un signal couleur modulé sur une porteuse couleur et que les filtres de signaux d'intégrateur (31, 32, 33) sont conçus pour le filtrage de la porteuse couleur.
